# EUROPEAN PATENT APPLICATION

(11) **EP 1 860 695 A2**
(43) Date of publication of application: **28.11.2007**
(21) Application number: 07251481.3
(22) Date of filing: 03.04.2007
(51) Int. Cl.: H01L 23/473

(54) **System and method of jet impingement cooling with extended surfaces**

(30) Priority: 24.05.2006 US 420184
(71) Applicant: Raytheon Company, Tucson AZ 85734-1337 (US)
(72) Inventor: Rummell, Kerrin A, Texas 75080 (US)
(74) Representative: Lawrence, John

(57) **Abstract**

According to one embodiment of the invention, a cooling system (10) for a heat-generating structure (12) comprises a channel (23, 24), a surface enhancing structure, and a fluid dispenser. The channel has an inlet (25) and an exit (27). The inlet is operable to receive a fluid coolant into the channel substantially in the form of a liquid. The exit is operable to dispense of the fluid coolant out of the channel at least partially in the form of a vapor. The surface enhancing structure extends into the channel (23, 24) and is operable to receive thermal energy from the heat-generating structure (12) and transfer at least a portion of the thermal energy to the fluid coolant. The thermal energy from the heat-generating structure causes at least a portion of the fluid coolant substantially in the form of a liquid to boil and vaporize in the channel (23, 24) upon contact with the surface enhancing structure. The fluid dispenser is operable to deposit fluid coolant onto the surface enhancing structure.

## Description

### RELATED APPLICATIONS

This application is a Continuation-in-Part of U.S. Patent Application No. 11/290,065 filed on November 30, 2005.

### TECHNICAL FIELD OF THE INVENTION

This invention relates generally to the field of cooling systems and, more particularly, to a system and method of jet impingement cooling with extended surfaces.

### BACKGROUND OF THE INVENTION

A variety of different types of structures can generate heat or thermal energy in operation. To prevent such structures from over heating, a variety of different types of cooling systems may be utilized to dissipate the thermal energy. To facilitate the dissipation of such thermal energy in such cooling systems, a variety of different types of coolants may be utilized.

### SUMMARY OF THE INVENTION

According to one embodiment of the invention, a cooling system for a heat-generating structure comprises a channel, a surface enhancing structure, and a fluid dispenser. The channel has an inlet and an exit. The inlet is operable to receive a fluid coolant into the channel substantially in the form of a liquid. The exit is operable to dispense of the fluid coolant out of the channel at least partially in the form of a vapor. The surface enhancing structure extends into the channel and is operable to receive thermal energy from the heat generating structure and transfer at least a portion of the thermal energy to the fluid coolant. The thermal energy from the heat-generating structure causes at least a portion of the fluid coolant substantially in the form of a liquid to boil and vaporize in the channel upon contact with the surface enhancing structure. The fluid dispenser is operable to deposit fluid coolant onto the surface enhancing structure.

Certain embodiments of the invention may provide numerous technical advantages. For example, a technical advantage of one embodiment may include the capability to enhance heat transfer in a coolant stream. Other technical advantages of other embodiments may include the capability to utilize pin fin configurations to alter the heat transfer phenomenology and thereby enhance the transfer of thermal energy. Yet other technical advantages of other embodiments may include the capability to utilize a surface enhancement structure in conjunction with a fluid dispenser to enhance the transfer of thermal energy.

Although specific advantages have been enumerated above, various embodiments may include all, some, or none of the enumerated advantages. Additionally, other technical advantages may become readily apparent to one of ordinary skill in the art after review of the following figures and description.

### BRIEF DESCRIPTION OF THE DRAWINGS

For a more complete understanding of example embodiments of the present invention and its advantages, reference is now made to the following description, taken in conjunction with the accompanying drawings, in which:
FIGURE 1 is a block diagram of an embodiment of a cooling system that may be utilized in conjunction with other embodiments;
FIGURE 2A is an isolated perspective view of a pin fin configuration, according to an embodiment of the invention;
FIGURE 2B is a side cross-sectional view of a pin fin configuration, according to an embodiment of the invention;
FIGURE 3A shows pin fin configurations, according to embodiments of the invention;
FIGURE 3B shows a graph comparing performance of the pin fin configurations; and
FIGURES 4A and 4B shows pin fin/fluid dispenser configurations, according to embodiments of the invention; and
FIGURES 5A, 5B, and 5C show pin fin/fluid dispenser configurations, according to embodiments of the invention.

### DETAILED DESCRIPTION OF EXAMPLE EMBODIMENTS OF THE INVENTION

It should be understood at the outset that although example embodiments of the present invention are illustrated below, the present invention may be implemented using any number of techniques, whether currently known or in existence. The present invention should in no way be limited to the example embodiments, drawings, and techniques illustrated below, including the embodiments and implementation illustrated and described herein. Additionally, the drawings are not necessarily drawn to scale.

To enhance the transfer of a heat or thermal energy away from a heat generating structure, micro-fins, microchannels, and micro-heat pipes have been proposed. However, such proposed structures are not only expensive to produce, but they also have had limited success. Accordingly, teaching of some embodiments of the invention recognize that a surface enhancement device such as pin fins can be used in conjunction with a fluid dispenser to enhance the transfer of heat or thermal energy.

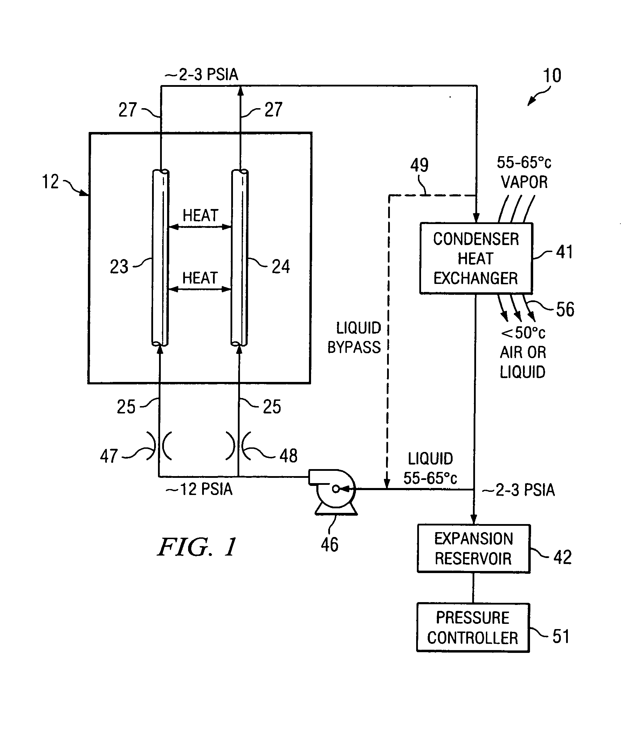

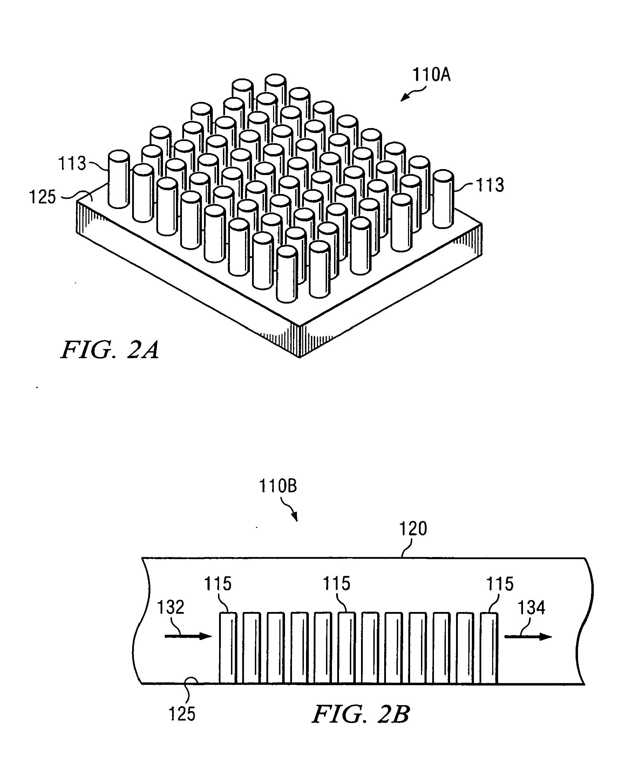

FIGURE 1 is a block diagram of an embodiment of a cooling system 10 that may be utilized in conjunction with other embodiments disclosed herein, namely surface enhancement and fluid dispenser embodiments described with reference to FIGURES 2A-5C. Although the details of one cooling system will be described below, it should be expressly understood that other cooling systems may be used in conjunction with embodiments of the invention.

The cooling system 10 of FIGURE 1 is shown cooling a structure 12 that is exposed to or generates thermal energy. The structure 12 may be any of variety of structure, including, but not limited to, electronic components and circuits. Because the structure 12 can vary greatly, the details of structure 12 are not illustrated and described. The cooling system 10 of FIGURE 1 includes channels 23 and 24, pump 46, inlet orifices 47 and 48, a condenser heat exchanger 41, an expansion reservoir 42, and a pressure controller 51.

The structure 12 may be arranged and designed to conduct heat or thermal energy to the channels 23, 24. To receive this thermal energy or heat, the channels 23, 24 may be disposed on an edge of the structure 12 or may extend through portions of the structure 12, for example, through a thermal plane of structure 12. In particular embodiments, the channels 23, 24 may extend up to the components of the structure 12, directly receiving thermal energy from the components. Although two channels 23, 24 are shown in the cooling system 10 of FIGURE 1, one channel or more than two channels may be used to cool the structure 12 in other cooling systems.

In operation, a fluid coolant flows through each of the channels 23, 24. As discussed later, this fluid coolant may be a two-phase fluid coolant, which enters inlet conduits 25 of channels 23, 24 in liquid form. Absorption of heat from the structure 12 causes part or all of the liquid coolant to boil and vaporize such that some or all of the fluid coolant leaves the exit conduits 27 of channels 23, 24 in a vapor phase. To facilitate such absorption or transfer of thermal energy, the channels 23, 24 may be lined with pin fins or other similar surface enhancement devices which, among other things, increase surface contact between the fluid coolant and walls of the channels 23, 24. Additionally, in particular embodiments, the fluid coolant may dispensed into the channels 23,24 using a jet dispenser or spray dispenser to ensure fluid contact between the fluid coolant and the walls of the channels 23, 24 (and any surface enhancement devices, including pin fins). Further details of the surface enhancement/fluid dispenser embodiments are described below with reference to FIGURE 2A-5C.

The fluid coolant departs the exit conduits 27 and flows through the condenser heat exchanger 41, the expansion reservoir 42, a pump 46, and a respective one of two orifices 47 and 48, in order to again to reach the inlet conduits 25 of the channels 23, 24. The pump 46 may cause the fluid coolant to circulate around the loop shown in FIGURE 1. In particular embodiments, the pump 46 may use magnetic drives so there are no shaft seals that can wear or leak with time.

The orifices 47 and 48 in particular embodiments may facilitate proper partitioning of the fluid coolant among the respective channels 23, 24 , and may also help to create a large pressure drop between the output of the pump 46 and the channels 23, 24 in which the fluid coolant vaporizes. The orifices 47 and 48 may have the same size, or may have different sizes in order to partition the coolant in a proportional manner which facilitates a desired cooling profile.

A flow 56 of fluid (either gas or liquid) may be forced to flow through the condenser heat exchanger 41, for example by a fan (not shown) or other suitable device. In particular embodiments, the flow 56 of fluid may be ambient fluid. The condenser heat exchanger 41 transfers heat from the fluid coolant to the flow 56 of ambient fluid, thereby causing any portion of the fluid coolant which is in the vapor phase to condense back into a liquid phase. In particular embodiments, a liquid bypass 49 may be provided for liquid fluid coolant that either may have exited the channels 23, 24 or that may have condensed from vapor fluid coolant during travel to the condenser heat exchanger 41.

The liquid fluid coolant exiting the condenser heat exchanger 41 may be supplied to the expansion reservoir 42. Since fluids typically take up more volume in their vapor phase than in their liquid phase, the expansion reservoir 42 may be provided in order to take up the volume of liquid fluid coolant that is displaced when some or all of the coolant in the system changes from its liquid phase to its vapor phase. The amount of the fluid coolant which is in its vapor phase can vary over time, due in part to the fact that the amount of heat or thermal energy being produced by the structure 12 will vary over time, as the structure 12 system operates in various operational modes.

Turning now in more detail to the fluid coolant, one highly efficient technique for removing heat from a surface is to boil and vaporize a liquid which is in contact with a surface. As the liquid vaporizes in this process, it inherently absorbs heat to effectuate such vaporization. The amount of heat that can be absorbed per unit volume of a liquid is commonly known as the latent heat of vaporization of the liquid. The higher the latent heat of vaporization, the larger the amount of heat that can be absorbed per unit volume of liquid being vaporized.

The fluid coolant used in the embodiment of FIGURE 1 may include, but is not limited to mixtures of antifreeze and water. In particular embodiments, the antifreeze may be ethylene glycol, propylene glycol, methanol, or other suitable antifreeze. In other embodiments, the mixture may also include fluoroinert. In particular embodiments, the fluid coolant may absorb a substantial amount of heat as it vaporizes, and thus may have a very high latent heat of vaporization.

Water boils at a temperature of approximately 100°C at an atmospheric pressure of 14.7 pounds per square inch absolute (psia). In particular embodiments, the fluid coolant's boiling temperature may be reduced to between 55-65°C by subjecting the fluid coolant to a subambient pressure of about 2-3 psia. Thus, in the cooling system 10 of FIGURE 1, the orifices 47 and 48 may permit the pressure of the fluid coolant downstream from them to be substantially less than the fluid coolant pressure between the pump 46 and the orifices 47 and 48, which in this embodiment is shown as approximately 12 psia. The pressure controller 51 maintains the coolant at a pressure of approximately 2-3 psia along the portion of the loop which extends from the orifices 47 and 48 to the pump 46, in particular through the channels 23 and 24, the condenser heat exchanger 41, and the expansion reservoir 42. In particular embodiments, a metal bellows may be used in the expansion reservoir 42, connected to the loop using brazed joints. In particular embodiments, the pressure controller 51 may control loop pressure by using a motor driven linear actuator that is part of the metal bellows of the expansion reservoir 42 or by using small gear pump to evacuate the loop to the desired pressure level. The fluid coolant removed may be stored in the metal bellows whose fluid connects are brazed. In other configurations, the pressure controller 51 may utilize other suitable devices capable of controlling pressure.

In particular embodiments, the fluid coolant flowing from the pump 46 to the orifices 47 and 48 may have a temperature of approximately 55°C to 65°C and a pressure of approximately 12 psia as referenced above. After passing through the orifices 47 and 48, the fluid coolant may still have a temperature of approximately 55°C to 65°C, but may also have a lower pressure in the range about 2 psia to 3 psia. Due to this reduced pressure, some or all of the fluid coolant will boil or vaporize as it passes through and absorbs heat from the channels 23 and 24.

After exiting the exits ports 27 of the channels 23, 24, the subambient coolant vapor travels to the condenser heat exchanger 41 where heat or thermal energy can be transferred from the subambient fluid coolant to the flow 56 of fluid. The flow 56 of fluid in particular embodiments may have a temperature of less than 50°C. In other embodiments, the flow 56 may have a temperature of less than 40°C. As heat is removed from the fluid coolant, any portion of the fluid which is in its vapor phase will condense such that substantially all of the fluid coolant will be in liquid form when it exits the condenser heat exchanger 41. At this point, the fluid coolant may have a temperature of approximately 55°C to 65°C and a subambient pressure of approximately 2 psia to 3 psia. The fluid coolant may then flow to pump 46, which in particular embodiments 46 may increase the pressure of the fluid coolant to a value in the range of approximately 12 psia, as mentioned earlier. Prior to the pump 46, there may be a fluid connection to an expansion reservoir 42 which, when used in conjunction with the pressure controller 51, can control the pressure within the cooling loop.

It will be noted that the embodiment of FIGURE 1 may operate without a refrigeration system. In the context of electronic circuitry, such as may be utilized in the structure 12, the absence of a refrigeration system can result in a significant reduction in the size, weight, and power consumption of the structure provided to cool the circuit components of the structure 12.

Although components of one embodiment of a cooling system 10 have been shown in FIGURE 1, it should be understood that other embodiments of the cooling system 10 can include more, less, or different component parts. For example, although specific temperatures and pressures have been described for one embodiment of the cooling system, other embodiments of the cooling system 10 may operate at different pressures and temperatures. Additionally, in some embodiments a coolant fill port and/or a coolant bleed port may be utilized with metal-to-metal caps to seal them. Further, in some embodiments, all or a portion of the joints between various components may be brazed, soldered or welded using metal-to-metal seal caps.

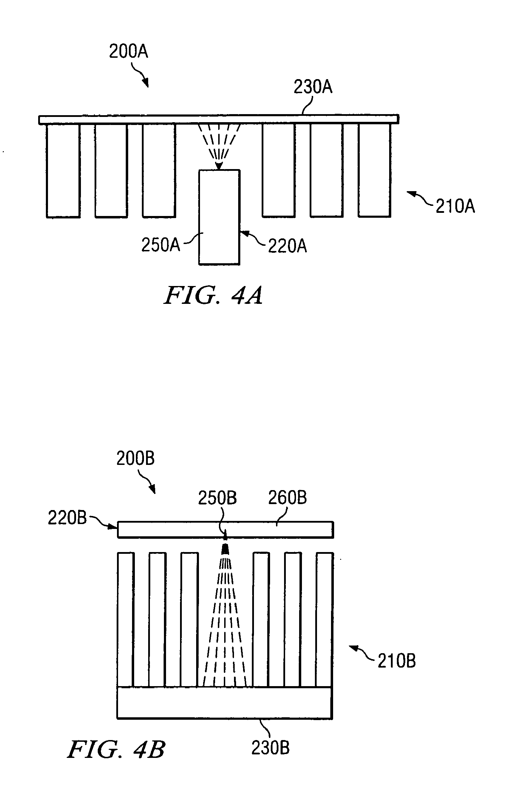

FIGURE 2A is an isolated perspective view of a pin fin configuration 110A and FIGURE 2B is a side cross-sectional view of a pin fin configuration 110B that may be utilized in embodiments of the invention. In particular embodiments, the pin fin configurations 110A, 110B may be disposed within the channels 23, 24 described with reference to FIGURE 1. In other embodiments, the pin fin configurations 110A, 110B may be disposed in other heat transfer structures. For purposes of illustration, the pin fin configurations 110A, 110B will be described as being disposed in a channel operable to receive fluid. The pin fin configurations 110A, 110B of FIGURES 2A and 2B are examples of surface enhancements that may be utilized to enhance the transfer of thermal energy from a heat generating structure to a fluid stream. Other types of surface enhancements that may be utilized with other embodiments of the invention include, but are not limited to, conductive foam and conductive fibers. As described below with reference to FIGURES 4A and 4B, these surface enhancements may be used in conjunction with fluid dispensers.

With reference to FIGURES 2A and 2B, a plurality of pin fins 113, 115 protrude from channel walls 125 and are arranged in pin fin configurations 110A, 110B. Pin fin configuration 110A shows a staggered arrangement and pin fin configuration 110B shows an inline arrangement. FIGURE 2B additionally shows a channel 120 with a fluid flow towards the pin fin configuration 110B, indicated by arrow 132, and a fluid flow away from the pin fin configuration 110B, indicated by arrow 134. In operation, thermal energy is transferred to the pin fins 113, 115 (e.g., from the channel wall 125 to the pin fins 113, 115) and to a fluid traveling through the channel, for example, channel 120. In particular embodiments, the pin fin configurations 110A, 110B may be utilized to enhance boiling heat transfer. In such embodiments, liquid fluid coolant (e.g., traveling in direction of arrow 132 towards the pin fins 113, 115) comes in contact with the pin fins 113, 115 and is boiled and vaporized. The vaporized fluid coolant (e.g., traveling away from the pin fins in direction of arrow 134) inherently contains the thermal energy transferred from the pin fins 113, 115 to the fluid coolant during vaporization. In particular embodiments, a portion or all of the fluid flow of the cross-flowing fluid coolant stream can be created by fluid dispensers that are described in greater detail with reference to FIGURES 4A-5C.

Teachings of some embodiments of the invention recognize that pin fins configurations, such as pin fin configurations 110A, 110B, can be utilized in cross-flowing coolant streams to alter the heat transfer phenomenology and thereby enhance heat transfer. By using pin fin configuration 110A, 110B, the cross flowing coolant creates jet-impingement-like flows of coolant that impact the surfaces of the plurality of pin fins 113, 115. As vapor is produced in the transfer of heat to the fluid coolant, the velocity of the coolant increases, which further increases the impacting velocity of the cross flowing coolant on the pin fins 113, 115. The effusing vapor also causes a near chaotic flow of vapor with embedded liquid coolant that impacts the pins fins 113, 115. That is, a situation is created where globs of liquid coolant (e.g., formed from the vaporization of other liquid coolant) are thrown against downstream pin fins 113, 115 - creating a spray cooling-like quality. Accordingly, the pin fin configurations 110A, 110B allow a cross flowing coolant to be used while taking advantage of the attributes of jet impingement and spray cooling, which are provided by the chaotic cross flowing liquid impacting the pins.

The pin fins 113, 115 may be made of a variety of materials and may take on a variety of sizes and shapes. In this embodiment, the pin fins are made of a nickel plated copper and vary in size from 0.04 inches high to 0.1675 inches high. The pin fins 113, 115 are shown with a columnar shape. In other embodiments, the pin fins 113, 115 may be made of other materials, may have heights less than 0.04 inches, may have heights greater than 0.1675 inches, and may have shapes other than columnar shapes. Additionally, in other embodiments the pin fins 113, 115 may be arranged in configurations other than inline or staggered configurations. Further, in particular embodiments, the pin fins may be made of a conductive foam or conductive fiber.

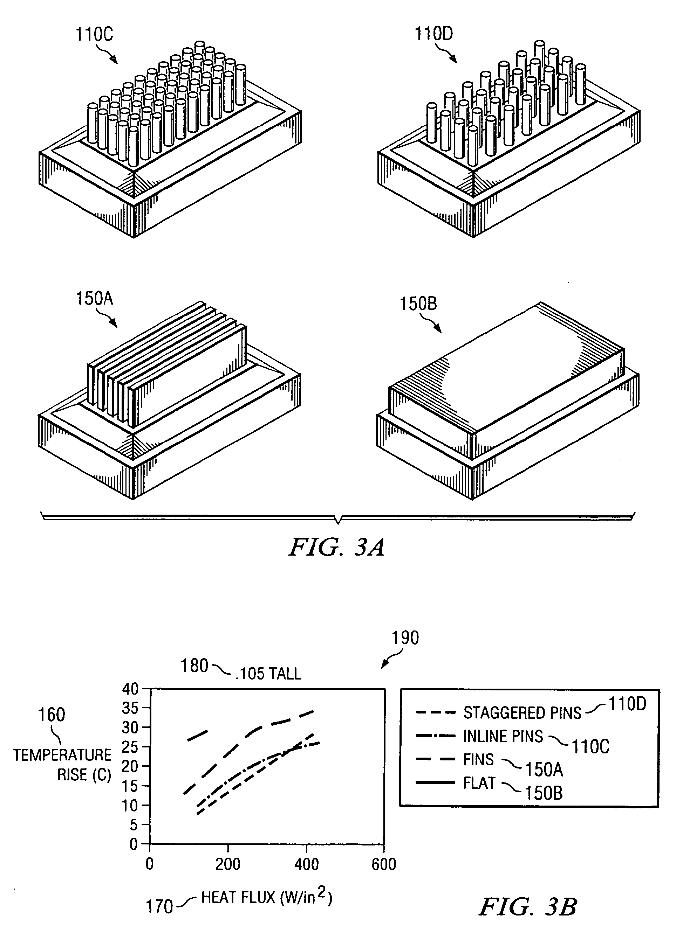

FIGURE 3A shows pin fin configurations 110C, 110D, according to embodiments of the invention. Pin fin configuration 110C is an inline configuration and pin fin configuration 110D is a staggered configuration. The pin configurations 110C and 110D may operate in a similar manner, may have similar or different shapes and sizes, and may be made from similar or different materials than the pin fin configurations 110A, 110B described with reference to FIGURES 2A and 2B. The pin fin configurations 110C, 110D are shown alongside a conventional fin stock configuration 150A and a conventional flat heat transfer configuration 150B.

FIGURE 3B shows a graph 190 comparing performance of the pin fin configurations 110C, 110D against the conventional fin stock configuration 150A and the conventional flat heat transfer configuration 150B. The graph 190 shows measured results of heat flux 170 against temperature rise 160 for a 0.105 inch size 180 for the pin fin configurations 110C, 110D and the conventional fin stock configuration 150A. The graph shows that the amount of wall super heat is significantly less for the pin fin configurations 110C, 110D than the conventional fin stock configuration 150A and the conventional flat heat transfer configuration 150B. At higher heat fluxes, the flat heat transfer configuration 150B was not tested because it transitioned to film boiling.

FIGURES 4A and 4B shows pin fin/fluid dispenser configurations 200A, 200B, according to embodiments of the invention. The pin fin/fluid dispenser configurations 200A, 200B of FIGURES 4A and 4B include pin fin configurations 210A, 210B and fluid dispensers 220A, 220B. The pin fin configurations 210A, 210B may be similar or different to the pin fin configurations 110A, 110B, 110C, and 110D described with reference to FIGURES 2A, 2B, and 3A, including pin fins 210A, 210B that extend from a channel surface 230A, 230B. In particular embodiments, the pin fin/fluid dispenser configurations 200A, 200B may be used within the channels 23, 24 described with reference to FIGURE 1. In other embodiments, the pin fin/fluid dispenser configuration s200A, 200B may be disposed in other heat transfer structures.

The fluid dispensers 220A, 220B may generally include any structure capable of projecting or depositing a fluid onto one or both of the channel surface 230A, 230B and the pin fin configurations 210A, 210B. In particular embodiments, the fluid dispensers 220A, 220B may be jet dispensers operable to create jet flows of fluid. In other embodiments, the fluid dispensers 220A, 220B may be spray dispensers operable to create a spray of fluid. In yet other embodiments, the fluid dispensers 220A, 220B may be a combination of jet dispensers and spray dispensers. The fluid dispenser 220A of FIGURE 4A is a nozzle 250A. The fluid dispenser 220A of FIGURE 4B is an orifice plate 260B with one or more holes that serve as a nozzle 250B. In embodiments in which the pin fin configurations 210A, 210B are disposed across a cross-flowing fluid stream, the fluid dispensers 220A, 220B may generate a portion or all of the flow.

In operation of particular embodiments, the fluid dispensers 220A, 220B directly impinge fluid on the channel surface 230A, 230B and the pin fin configurations 210A, 210B, thereby realize a higher two-phase heat transfer coefficient. In such embodiments, the pin fin configurations 210A, 210B ensure that entrained vapor bubbles do not impede a replenishment of liquid coolant to the heated surface and that no vapor films can develop. Further, in particular embodiments, the fluid dispensers 220A, 220B may further enhance the throwing of globs liquid coolant (e.g., formed from the vaporization of other liquid coolant) against downstream pin fins 210A, 210B, described with reference to FIGURES 2A and 2B.

In particular embodiments, some of the pins 210A, 210B directly adjacent the nozzles 250A, 250B may be removed to allow fluid to be deposited directly to the channel surface 230A, 230B. Additionally, as briefly referenced, above, in particular embodiments, other types of surface enhancements materials may include conductive foam or conductive fibers.

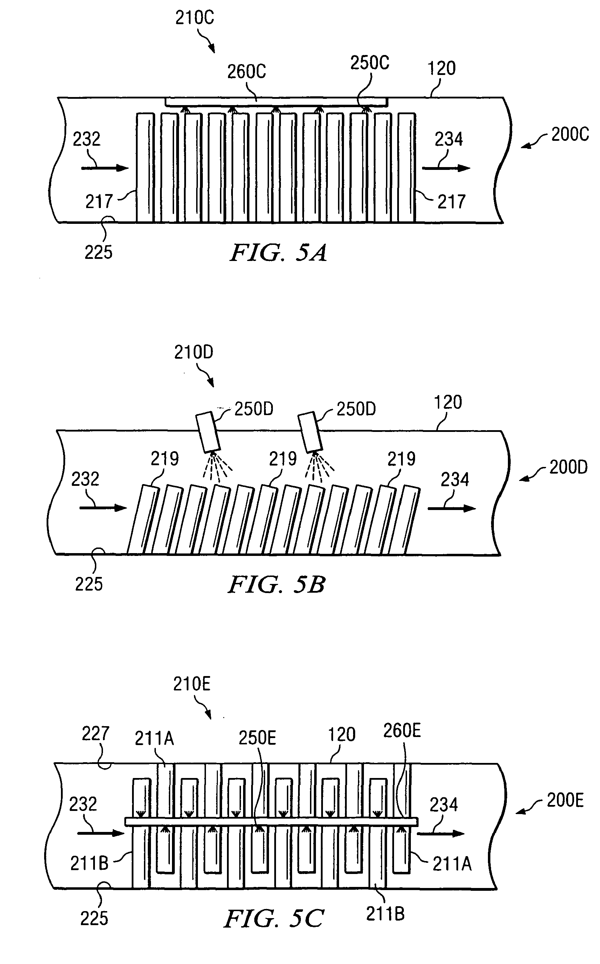

FIGURES 5A, 5B, and 5C show pin fin/fluid dispenser configuration 200C, 200D, and 200E, according to embodiments of the invention. The pin fin/fluid dispenser configuration 200C, 200D, and 200E of FIGURES 5A, 5B, and 5C are intended as illustrating some of the variety of pin fin/fluid dispenser configurations that may be utilized, according to embodiments of the inventions. Although several are specifically shown, others will become apparent to one of ordinary skill in the art after review of this specification. The pin fin/fluid dispenser configurations 200C, 200D, and 200E may operate in a similar manner and may be made from similar or different materials than the pin fin/fluid dispenser configuration 200A and 200B, described with reference to FIGURES 4A and 4B. Each of the pin fin/fluid dispenser configuration 200C, 200D, and 200E of FIGURES 5A, 5B, and 5C is shown with a channel 120 with a fluid flow towards pin fin configurations 210C, 210D, and 210E, indicated by arrow 232, and a fluid flow away from the pin fin configuration configurations 210C, 210D, and 210E,, indicated by arrow 234. Each of the pin fin configurations 210C, 210D, and 210E of FIGURES 4A, 4B, and 4C is additionally shown extending from a channel wall 225 that may be in thermal communication with a heat generating structure (e.g., heat generating structure 12 of FIGURE 1).

FIGURE 5A shows that pin fins 217 in pin fin configuration 210C may extend substantially across a channel 120 and that an orifice plate 260C may have a plurality of nozzles 250C to deposit fluid coolant on each of the pin fins 217. In other embodiments, the pin fins 217 may only extend a portion of the distance across a channel. Additionally, although the pin fins 217 are show as all the same length, in other embodiments the pin fins 217 may be different lengths.

FIGURE 5B shows that pin fins 219 in pin fin configuration 210D may tilt at an angle and be deposited with nozzles 250D, also tilted at an angle. Although the pin fins 219 and nozzles 250D are shown tilting at a downstream angle from the fluid flow in this embodiment, in other embodiments, one or both of the pin fins 219 and nozzles 250D may tilt at an upstream angle. And, in some embodiments, some of the pin fins 219 and the nozzles 250D may tilt in one direction and others of the pin fins 219 and the nozzles 250D may tilt in a different direction. Similar to that described above, in particular embodiments, the pin fins 219 may also be different lengths.

FIGURE 5C shows that pin fins 211A, 211B in pin fin configuration 210E may extend from different channel walls 225, 227 and that an orifice 260E with a plurality of nozzles 250E pointing towards different walls 225, 227 may extend through a center of the channel 120. Similar to that described above, in particular embodiments, the pin fins 211A, 211B may also be different lengths and tilt in different directions.

Although the present invention has been described with several embodiments, a myriad of changes, variations, alterations, transformations, and modifications may be suggested to one skilled in the art, and it is intended that the present invention encompass such changes, variations, alterations, transformation, and modifications as they fall within the scope of the appended claims.

## Claims

1. A cooling system for a heat-generating structure, the cooling system comprising:
a channel having a surface, an inlet and an exit, the surface in thermal communication with the heat-generating structure, the inlet operable to receive a fluid coolant into the channel substantially in the form of a liquid, and the exit operable to dispense of the fluid coolant out of the channel at least partially in the form of a vapor;
a surface enhancing structure extending into the channel and in thermal communication with the surface, the surface and the surface enhancing structure operable to receive thermal energy from the heat generating structure and transfer at least a portion of the thermal energy to the fluid coolant, the thermal energy from the heat-generating structure causing at least a portion of the fluid coolant substantially in the form of a liquid to boil and vaporize in the channel upon contact with the surface enhancing structure and the surface; and
a fluid dispenser operable to deposit fluid coolant onto the surface enhancing structure and the surface.

2. The cooling system of Claim 1, wherein the surface enhancing structure is or includes conductive fibers.

3. The cooling system of Claim 1, wherein the surface enhancing structure is, or includes, conductive foam.

4. The cooling system of claim 1, wherein the surface enhancing structure is, or includes, a plurality of pin fins.

5. The cooling system of any preceding claim, wherein the fluid dispenser is a jet dispenser.

6. The cooling system of any one of Claims 1 to 4, wherein the fluid dispenser is a spray dispenser.

7. A cooling system for a heat-generating structure, the cooling system comprising:
a channel having an inlet and an exit, the inlet operable to receive a fluid coolant into the channel substantially in the form of a liquid, and the exit operable to dispense of the fluid coolant out of the channel at least partially in the form of a vapor;
a surface enhancing structure extending into the channel, the surface enhancing structure operable to receive thermal energy from the heat generating structure and transfer at least a portion of the thermal energy to the fluid coolant, the thermal energy from the heat-generating structure causing at least a portion of the fluid coolant substantially in the form of a liquid to boil and vaporize in the channel upon contact with the surface enhancing structure; and
a fluid dispenser operable to deposit fluid coolant onto the surface enhancing structure and the surface.

8. The cooling system of Claim 7, wherein:
the channel includes a surface in thermal communication with the heat-generating structure,
the surface enhancing structure is in thermal communication with the surface, and
the fluid dispenser is further operable to deposit fluid coolant onto the surface.

9. The cooling system of Claim 7 or claim 8, wherein the surface enhancing structure is, or includes, a plurality of pin fins.

10. The cooling system of Claim 7 or Claim 8, wherein the surface enhancing structure is, or includes, conductive foam.

11. The cooling system of Claim 7 or Claim 8, wherein the surface enhancing structure is, or includes, conductive fibers.

12. The cooling system of any one of Claims 7 or Claim 8, wherein the fluid dispenser is a jet dispenser.

13. The cooling system of Claim 12, wherein the surface enhancing structure is a plurality of pin fins.

14. The cooling system of any one of Claims 7 or claim 8, wherein the fluid dispenser is a spray dispenser.

15. The cooling system of Claim 14, wherein the surface enhancing structure is a plurality of pin fins.

16. The cooling system of Claim 15, wherein the plurality of pin fins are perpendicular to a wall of the channel.

17. The cooling system of any one of Claim 7 to 16, further comprising:
a structure which reduces a pressure of the fluid coolant to a subambient pressure at which the fluid coolant has a boiling temperature less than a temperature of the heat-generating structure.

18. A method for cooling a heat-generating structure, the method comprising:
transferring thermal energy from the heat generating structure to a surface enhancing structure disposed in a channel;
depositing, with a fluid dispenser, fluid coolant onto the surface enhancing structure; and
transferring at least a portion of the thermal energy from the surface enhancing structure to the fluid coolant.

19. The method of Claim 18, wherein transferring at least a portion of the thermal energy from the plurality of pin fins to the fluid coolant vaporizes at least a portion of the fluid coolant.

20. The method of Claim 18 or Claim 19, further comprising:
reducing a pressure of the fluid coolant to a subambient pressure at which the fluid coolant has a boiling temperature less than a temperature of the heat-generating structure.
